# EUROPÄISCHE PATENTANMELDUNG

(11) **EP 4 585 929 A2**
(43) Veröffentlichungstag der Anmeldung: **16.07.2025**
(21) Anmeldenummer: 25150479.1
(22) Anmeldetag: 07.01.2025
(51) Int. Cl.: G01R 1/04, G01R 11/02, G01R 11/04, G01R 15/04, G01R 15/14, G01R 22/06, G01R 1/20, G01R 19/25, G01D 4/00, H05K 1/02, H02J 13/00

(54) **MESSGERÄT FÜR ELEKTRISCHE GRÖSSEN**

(30) Priorität: 11.01.2024 DE 102024100779
(71) Anmelder: TQ-Systems GmbH, 82229 Seefeld (DE)
(72) Erfinder: Melzer, Raik, 09247 Chemnitz (DE); Köthe, Daniel, 09131 Chemnitz (DE)
(74) Vertreter: Grättinger Möhring von Poschinger Patentanwälte Partnerschaft mbB

(57) **Zusammenfassung**

Ein Messgerät (1) für elektrische Größen umfasst ein Gehäuse (3), eine Messplatine (31) und einer Kommunikationsplatine (33). Die Messplatine (31) ist bestückt mit einem Spannungsanschluss (53), einem Spannungsteiler (57), mindestens einem ersten CT-Anschluss (51) zum Anschließen mindestens eines externen Stromwandlers (49), einem mit dem Spannungsteiler (57) und dem ersten CT-Anschluss (51) elektrisch verbundenen ersten Mess-Chip (45) zum Bestimmen der elektrischen Größen und zum Ausgeben der elektrischen Größen als Messdaten an einen ersten Teil (35A) eines Steckverbinders (35). Die Kommunikationsplatine (33) ist mit einem zweiten Teil (35B) des Steckverbinders (35), der zusammen mit dem ersten Teil (35A) eine elektrische Steckverbindung zwischen der Kommunikationsplatine (33) und der Messplatine (31) bewirkt, einem Datenkommunikationschip (43), der zum Empfangen der Messdaten vom ersten Mess-Chip (45) mit dem zweiten Teil (35B) elektrisch verbunden und galvanisch getrennt ist, wobei eine galvanische Trennung zwischen dem ersten Mess-Chip (45) und dem Datenkommunikationschip (43) auf der Kommunikationsplatine (33) vorgesehen ist, mindestens einem mit dem Datenkommunikationschip (43) elektrisch verbundenen Datenanschluss (59) und mindestens einer mit dem Datenkommunikationschip elektrisch verbundenen Benutzerschnittstelle (61) bestückt.

## Beschreibung

Die Erfindung betrifft ein Messgerät für elektrische Größen mit einem oder mehreren externen Stromwandlern. Das Messgerät ist kompakt ausgelegt, wird auch als Energiezähler bezeichnet und ist insbesondere für eine Befestigung an einer Hutschiene vorgesehen. Ferner betrifft eine weitere Erfindung ein elektronisches Gerät mit einem verriegelten zweiteiligen Rastgehäuse. Ferner betrifft eine weitere Erfindung eine elektronische Schaltungsanordnung zur Spannungs-/Strommessung in einem solchen Messgerät.

Messgeräte, die mithilfe von externen Stromwandlern elektrische Größen wie Strom, Spannung, Leistung, Leistungsfaktor und/oder Frequenz erfassen, sind bekannt. Die Zielrichtung der hierin offenbarten Ausführungsformen liegt in der Anwendung, derartige Messgeräte unter begrenzten räumlichen Gegebenheiten wie z. B. in einem bereits fast voll belegten Schaltschrank einzusetzen. Ferner liegt eine weitere Zielrichtung darin, einen Einsatz in verschiedenen regionalen Einsatzgebieten mit eigenen regulatorischen Vorgaben zu ermöglichen.

Die gewünschte Funktionalität derartiger elektronischer Geräte wird mithilfe von elektronischen Bauteilen wie AC/DC-Netzteilen, DC/DC-Wandler, DC/DC-Isolatoren, Mess-ICs (hierin auch als Mess-Chips bezeichnet), Recheneinheiten, Widerstände, Kondensatoren, Schalter und Anschlüsse umgesetzt. Die elektronischen Bauteile sind üblicherweise auf einer Platine angeordnet und bilden zusammen ein Messsystem. Spezifische Bauteile bereiten die elektrischen Messgrößen geeignet auf und versorgen beispielsweise die Mess-Chip mit den Messgrößen. So wird beispielsweise eine zu messende Spannung aufbereitet und dem Mess-IC zugeführt. Zu messende elektrische Parameter werden u. a. von den angeschlossenen Stromwandlern bereitgestellt. Die vom elektronischen Gerät ermittelten elektrischen Größen werden ausgegeben und können beispielsweise für eine Steuerung von einer Mehrzahl von Strom generierenden und/oder Strom verbrauchenden Systemen genutzt werden.

Eine Aufgabe der hierin offenbarten Konzepte betrifft die Bereitstellung eines derartigen elektrischen Geräts als kompaktes Gerät, das insbesondere zur kostengünstigen Stromzählung wie für eine Messung von Einsatzdaten einzelner Verbraucher verwendet werden kann. Die elektrischen Geräte sollen in der Energieflusssteuerung mittels eines Energie-Managers und/oder im Rahmen einer dezentralen Messung einer Mehrzahl von Verbrauchern einsetzbar sein.

Die hierin offenbarten Konzepte sind darauf gerichtet, zumindest zum Teil einen oder mehrere Aspekte, die hinsichtlich des vielfältigen Einsatzes von elektronischen Geräten gegeben sind, zu verbessern. So liegt einem Aspekt dieser Offenbarung die Aufgabe zugrunde, den Raumbedarf möglichst gering zu halten (kompakter Aufbau). Weiteren Aspekten dieser Offenbarung liegen die Aufgaben zugrunde, Sicherheitsanforderungen zu erfüllen (sicherer Aufbau) und/oder eine kostengünstige Umsetzung zu ermöglichen (kostengünstiger Aufbau).

Zumindest eine dieser Aufgaben wird gelöst durch ein elektronisches Messgerät nach Anspruch 1 oder nach Anspruch 16 oder einem Elektrogerät nach Anspruch 15. Weiterbildungen sind in den Unteransprüchen angegeben.

In einem Aspekt umfasst ein Messgerät für elektrische Größen ein Gehäuse, eine Messplatine und einer Kommunikationsplatine, die in dem Gehäuse versetzt übereinander angeordnet sind, wobei die Messplatine bestückt ist mit einem Spannungsanschluss, einem mit dem Spannungsanschluss elektrisch verbundenen Spannungsteiler, mindestens einem ersten CT-Anschluss zum Anschließen mindestens eines externen Stromwandlers, einem mit dem Spannungsteiler und dem ersten CT-Anschluss elektrisch verbundenen ersten Mess-Chip zum Bestimmen der elektrischen Größen und zum Ausgeben der elektrischen Größen als Messdaten an einen ersten Teil eines Steckverbinders, und wobei die Kommunikationsplatine bestückt ist mit einem zweiten Teil des Steckverbinders, der zusammen mit dem ersten Teil eine elektrische Steckverbindung zwischen der Kommunikationsplatine und der Messplatine bewirkt, einem Datenkommunikationschip, der zum Empfangen der Messdaten vom ersten Mess-Chip mit dem zweiten Teil elektrisch verbunden und galvanisch getrennt ist, wobei eine galvanische Trennung zwischen dem ersten Mess-Chip und dem Datenkommunikationschip auf der Kommunikationsplatine vorgesehen ist, mindestens einem mit dem Datenkommunikationschip elektrisch verbundenen Datenanschluss und mindestens einer mit dem Datenkommunikationschip elektrisch verbundenen Benutzerschnittstelle.

In einem weiteren Aspekt umfasst ein Elektrogerät, insbesondere zum Messen elektrischer Größen, eine elektrische Schaltungsanordnung, insbesondere zum Bestimmen und Ausgeben der elektrischen Größen, die einen Spannungsanschluss und mindestens eine Benutzerschnittstelle umfasst und in einem Gehäuse angeordnet ist, wobei das Gehäuse als zweigeteiltes Gehäuse eine erste Schale und eine zweite Schale umfasst und eine Rastverbindung zum mechanischen Verbinden der ersten Schale mit der zweiten Schale aufweist, wobei die Rastverbindung von mindestens einem Rasthacken und mindestens einem Einrastbereich an entsprechend der ersten Schale und der zweiten Schale gebildet wird. Das Elektrogerät umfasst ferner ein im Gehäuse angeordnetes Formteil, das mindestens ein Blockade-Element ausbildet, das im eingebauten Zustand derart zum Rasthaken angeordnet ist, dass einem Ausrasten der Rastverbindung, insbesondere einem Verformen des Rasthakens in Richtung eines Gehäuseinneren, entgegengewirkt wird.

In einem weiteren Aspekt umfasst ein Messgerät für elektrische Größen eine elektrische Schaltungsanordnung, wobei die elektrische Schaltungsanordnung umfasst einen Spannungsanschluss, einen mit dem Spannungsanschluss elektrisch verbundenen Spannungsteiler, einen ersten CT-Anschluss zum Anschließen mindestens eines externen Stromwandlers und einen zweiten CT-Anschluss zum Anschließen mindestens eines externen Stromwandlers, einen mit dem Spannungsteiler und dem ersten CT-Anschluss elektrisch verbundenen ersten Mess-Chip zum Bestimmen und zum Ausgeben der elektrischen Größen als Messdaten für den mindestens einen mit dem am ersten CT-Anschluss angeschlossenen externen Stromwandler, einen mit dem Spannungsteiler und dem zweiten CT-Anschluss elektrisch verbundenen zweiten Mess-Chip zum Bestimmen und zum Ausgeben der elektrischen Größen als Messdaten für den mindestens einen mit dem am zweiten CT-Anschluss angeschlossenen externen Stromwandler, einen Datenkommunikationschip, der zum Empfangen, Verarbeiten und Ausgeben der Messdaten vom ersten Mess-Chip und vom zweiten Mess-Chip ausgebildet ist. Der Spannungsteiler ist zum Abgeben von Spannungen an den ersten Mess-Chip und den zweiten Mess-Chip ausgebildet und umfasst einen Spannungseingang zum Aufnehmen einer Eingangsspannung vom Spannungsanschluss, für jeden der Mess-Chips, einen Spannungsausgang zum Abgeben einer reduzierten Spannung an den jeweiligen Mess-Chip, einen mit dem Spannungseingang elektrisch verbundenen Widerstandsreihenabschnitt umfassend mehrere in Reihe geschaltete Widerstände, die zum Spannungsabfall für jeden der Mess-Chips beitragen, und einen mit einem letzten Widerstand der Widerstände des Widerstandsreihenabschnitts elektrisch verbundenen Parallelschaltungsabschnitt umfassend, für jeden Spannungsausgang, einen, die in Reihe geschaltete Widerstände des Widerstandsreihenabschnitts erweiternden und mit jeweils einem Spannungsausgang elektrisch verbundenen, ersten Widerstandsabschnitt umfassend mindestens einen Widerstand, einen den jeweiligen Spannungsausgang und einen Neutralleiter elektrisch verbindenden zweiten Widerstandsabschnitt umfassend mindestens einen Widerstand und einen den jeweiligen Spannungsausgang und den Neutralleiter elektrisch verbindenden Kondensatorabschnitt umfassend mindestens einen Kondensator.

Die Messgeräte und das Elektrogerät können wie nachfolgend beispielhaft zusammengefasst weitergebildet werden.

In einigen Weiterbildungen des Mess-/Elektrogeräts kann die Messplatine ferner bestückt sein mit einem AC/DC-Netzteil, das mit dem Spannungsanschluss elektrisch verbunden ist, zur Spannungsversorgung des ersten Mess-Chips, insbesondere über einen Linearregler, mit dem ersten Mess-Chip elektrisch verbunden ist und zur Spannungsversorgung des Datenkommunikationschips über die elektrische Steckverbindung und einem auf der Kommunikationsplatine angeordneten DC-Isolationselement galvanisch isoliert, insbesondere über ein DC/DC-Element zur Spannungsreduzierung, mit dem Datenkommunikationschip elektrisch verbunden ist.

In einigen Weiterbildungen des Mess-/Elektrogeräts kann der mindestens eine Datenanschluss einen Ethernet-Anschluss und/oder einen RS485-Anschluss umfassen und/oder die mindestens eine Benutzerschnittstelle eine LED-Anzeige und/oder einen Taster umfass.

In einigen Weiterbildungen des Mess-/Elektrogeräts kann das Gehäuse als zweigeteiltes Gehäuse eine erste Schale und eine zweite Schale umfassen, wobei die Messplatine in der ersten Schale und die Kommunikationsplatine in der zweiten Schale, jeweils insbesondere über eine Schraub- oder Rastverbindung, befestigt sein kann. Ferner kann die Steckverbindung insbesondere durch Zusammensetzen der ersten Schale und der zweiten Schale zur Ausbildung des Gehäuses bewirkt sein. Des Weiteren kann das Gehäuse eine Rastverbindung zum mechanischen Verbinden der ersten Schale mit der zweiten Schale aufweist und/oder Öffnungen, insbesondere in der ersten Schale, für den Spannungsanschluss und/oder den mindestens einen ersten CT-Anschluss, und/oder Öffnungen, insbesondere in der zweiten Schale, für den mindestens einen Datenanschluss und der mindestens einen Benutzerschnittstelle aufweist, wobei die Benutzerschnittstelle insbesondere über ein zwischen der Kommunikationsplatine und der zweiten Schale angeordnetes Lichtleiter-und/oder-Stößel-Element für einen Benutzer zugänglich gemacht ist.

In einigen Weiterbildungen des Mess-/Elektrogeräts kann das Gehäuse als zweigeteiltes Gehäuse eine erste Schale und eine zweite Schale umfassen und eine Rastverbindung zum mechanischen Verbinden der ersten Schale mit der zweiten Schale aufweisen, wobei die Rastverbindung von mindestens einem Rasthacken und mindestens einem Einrastbereich, insbesondere eine Öffnung, an entsprechend der ersten Schale und der zweiten Schale gebildet wird. Das Messgerät kann ferner ein zwischen der Messplatine und der Kommunikationsplatine angeordnetes Formteil mit mindestens einem Blockade-Element umfassen, wobei das mindestens eine Blockade-Element im eingebauten Zustand derart zu einem Rasthaken angeordnet ist, dass einem Ausrasten der Rastverbindung, insbesondere einem Verformen des zugehörigen Rasthakens in Richtung eines Gehäuseinneren, entgegengewirkt wird, ein Ausrasten insbesondere verhindert wird. Ferner kann die Rastverbindung auf gegenüberliegenden Seiten des Gehäuses angeordnete Rasthaken aufweisen und das Formteil kann derart ausgebildet sein, dass es einem Ausrasten mindestens eines der Rasthacken auf jeder Seite des Gehäuses entgegenwirkt.

In einigen Weiterbildungen des Mess-/Elektrogeräts kann das Formteil derart ausgebildet sein, dass es im eingebauten Zustand einen Mindestabstand zwischen der Messplatine und der Kommunikationsplatine bereitstellt, und insbesondere sicherstellt, der insbesondere auch bei fehlender Verbindung eines oder beider der Messplatine und der Kommunikationsplatine zur jeweiligen der ersten und zweiten Schale den Mindestabstand gewährleistet. Alternativ oder zusätzlich kann das Formteil aus einem elektrisch isolierenden Material ausgebildet sein.

In einigen Weiterbildungen des Mess-/Elektrogeräts kann das Formteil umfassen: mindestens einen Standfuß, der insbesondere im eingebauten Zustand in einem nicht-bestückten Bereich der Messplatine angeordnet ist und dessen Länge insbesondere eine Position des mindestens einen Blockade-Elements im Gehäuseinneren, und insbesondere den Mindestabstand zwischen der Messplatine und der Kommunikationsplatine, bestimmt, und/oder einen flächig ausgebildeten Strukturabschnitt, der das mindestens eine Blockade-Element räumlich zu dem mindestens einen Rasthaken positioniert, und/oder wobei das mindestens eine Blockade-Element im eingebauten Zustand in einem nicht-bestückten Bereich der Kommunikationsplatine angeordnet ist.

In einigen Weiterbildungen des Mess-/Elektrogeräts kann das Formteil und mindestens eine der ersten Schale und der zweiten Schale ein Führungssystem ausbilden, das zum Positionieren des Formteils beim Zusammenbau des Messgeräts und/oder zum Halten des Formteils im eingebauten Zustand ausgebildet ist, wobei das Führungssystem insbesondere eine Führungsschiene, insbesondere eine Nut, auf einer Innenwand einer der ersten Schale und der zweiten Schale oder am Formteil und eine entsprechend in die Führungsschiene, insbesondere in die Nut, eingreifendes Schlittenelement am Formteil oder auf der Innenwand einer der ersten Schale und der zweiten Schale umfasst.

In einigen Weiterbildungen des Mess-/Elektrogeräts kann der Spannungsteiler zum Abgeben von reduzierten Spannungen an mindestens zwei Mess-Chips für die Messung von elektrischen Größen mittels zwei an die jeweiligen Mess-Chips angeschlossenen externen Stromwandlern ausgebildet sein. Der Spannungsteiler kann umfassen: einen Spannungseingang, insbesondere zum Aufnehmen einer Netzspannung, für jeden der mindestens zwei Mess-Chips, einen Spannungsausgang zum Abgeben einer der reduzierten Spannungen an einen der mindestens zwei Mess-Chips, einen mit dem Spannungseingang elektrisch verbundenen Widerstandsreihenabschnitt umfassend mehrere in Reihe geschaltete Widerstände, die zum Spannungsabfall für jeden der mindestens zwei Mess-Chips beitragen, und eine mit einem letzten Widerstand der Widerstände des Widerstandsreihenabschnitts elektrisch verbundenen Parallelschaltungsabschnitt. Der Parallelschaltungsabschnitt kann umfassen: für jeden der mindestens zwei Mess-Chips einen die in Reihe geschaltete Widerstände des Widerstandsreihenabschnitts erweiternden und mit jeweils einem Spannungsausgang elektrisch verbundenen Widerstand und für jeden Spannungsausgang einen den jeweiligen Spannungsausgang und einem Neutralleiter elektrisch verbindenden Widerstand und einen den jeweiligen Spannungsausgang und den Neutralleiter elektrisch verbindenden Kondensator.

In einigen Weiterbildungen des Mess-/Elektrogeräts kann die Messplatine bestückt sei mit einem zweiten CT-Anschluss zum Anschließen mindestens eines externen Stromwandlers, und einem, mit dem Spannungsteiler und dem zweiten CT-Anschluss elektrisch verbundenen, zweiten Mess-Chip zum Bestimmen der elektrischen Größen und Ausgeben der elektrischen Größen an die Kommunikationsplatine als Messdaten für den mindestens einen mit dem am zweiten CT-Anschluss angeschlossenen externen Stromwandler, und wobei der erste Mess-Chip mit einem ersten Spannungsausgang und der zweite Mess-Chip mit einem zweiten Spannungsausgang elektrisch verbunden sind.

In einigen Weiterbildungen des Mess-/Elektrogeräts kann der Spannungsteiler zum Reduzieren einer Eingangsspannung in einem Bereich von 200 V bis 1000 V in einen Messpannungsbereich in einem Bereich von 0 V bis 3 V ausgebildet sein. Alternativ oder zusätzlich können die, die in Reihe geschalteten Widerstände des Widerstandsreihenabschnitts erweiternden, Widerstände zwischen dem jeweiligen Spannungsausgang und dem Neutralleiter eine Entkopplung zwischen den Spannungsausgängen bewirken.

In einigen Weiterbildungen des Mess-/Elektrogeräts können die Widerstände des Widerstandsreihenabschnitts einen Gesamtwiderstand in einen Bereich von 500 kS2 bis 10 MS2 ausbilden und/oder der Parallelschaltungsabschnitt einen Widerstand in einem Bereich von 100 Ω bis 10 kS2 ausbilden, sodass zusammen mit dem Widerstand zwischen dem jeweiligen Spannungsausgang und dem Neutralleiter eine Spannungsteilung am jeweiligen Spannungsausgang umgesetzt ist. Alternativ oder zusätzlich können für den jeweiligen Spannungsausgang die Widerstände des Widerstandsreihenabschnitts und der Widerstand zwischen dem jeweiligen Spannungsausgang und dem Neutralleiter mit dem Kondensator zwischen dem jeweiligen Spannungsausgang und dem Neutralleiter eine RC-Tiefpassfunktion ausbilden. Alternativ oder zusätzlich kann der Kondensator zwischen dem jeweiligen Spannungsausgang und dem Neutralleiter eine Pufferfunktion für den jeweiligen Spannungsausgang ausbilden.

In einigen Weiterbildungen kann das Mess-/Elektrogerät einen weiteren CT-Anschluss zum Anschließen eines weiteren externen Stromwandlers und einen weiteren Mess-Chip umfassen und der Parallelschaltungsabschnitt kann ferner für einen weiteren, dem weiteren Mess-Chip zugeordneten, Spannungsausgang einen weiteren ersten Widerstandsabschnitt, einen weiteren zweiten Widerstandsabschnitt und einen weiteren Kondensatorabschnitt umfassen.

Die hierin vorgeschlagenen Erfindungen betreffen insbesondere Energie- und Leistungsmessgeräte mit einer kompakten Bauform. Dabei kann die Funktionalität des elektronischen Geräts z. B. auf (nur) zwei Baugruppen, hier Anordnungen von elektronischen Bauteilen auf einer eigenen Platine, aufgeteilt werden, wobei die Platinen mit einem Steckverbinder verbunden sind. Die elektronischen Geräte sind insbesondere zur Befestigung an einer Hutschiene ausgelegt und weisen beispielsweise eine Baubreite von ein oder zwei Teilungseinheiten (Breite einer Teilungseinheit z. B. 18 mm) auf. Insbesondere bei ein oder zwei Teilungseinheiten sind die Geräte entsprechend im bereitgestellten Bauvolumen (Gehäuseinnenvolumen) beschränkt.

Die Verwendung der erfindungsgemäßen Messgeräte erfolgt mit modular anschließbaren Stromwandlern, wobei die gemessenen Größen beispielsweise zur Steuerung von Energieerzeugern und -verbrauchern dienen können. Allgemein ist die vorgesehene Verwendung die eines Echtzeit-Messgeräts, wie es z. B. für ein Energiemanagement mit dem Ziel der Optimierung des Eigenverbrauchs aus der Photovoltaik-Anlage mit Speicher und z.B. einer Ladesäule eingesetzt wird. Insbesondere sind die erfindungsgemäßen Messgeräte zum Anschluss von drei bzw. sechs kompakten und preisgünstigen Klapp- bzw. Clamp-On-Stromwandlern für die Stromerfassung von z. B. 50 A bis 600 A (bei 0,333 V bzw. einem mA-Ausgang) ausgelegt. Öffnungen der Stromwandler liegen beispielsweise im Bereich von 10 mm bis40 mm. Ferner kann eine sogenannte Sensorbar mit beispielsweise drei nebeneinander angeordneten Stromwandlern verwendet werden.

Die erfindungsgemäßen Messgeräte können unterschiedlichste Vorteile gegenüber dem Stand der Technik aufweisen. So können sich zum Beispiel folgende Vorteile ergeben:
- sehr kompakte Bauform in 2 TE
- Einsatz im Spannungsbereich 200 V - 400 V
- Einsatz in Bereichen der Überspannungskategorie III
- Verwendung mit z. B. drei oder sechs Stromtransformatoren
- Auswertung mit sehr geringem Messintervall von z. B. 100 ms
- hohe Genauigkeit der erfassten Momentanwerte von Strom, Spannung, Leistung, Leistungsfaktor und/oder Frequenz
- sehr kompakte Bauform von Geräten mit z. B. mehreren Schnittstellen wie LAN- und RS485
- galvanisch getrennte Schnittstellen (RS485 / Ethernet)
- vielfältige Ausgabe der Daten als Modbus RTU/TCP, SUNSPEC und kundenspezifischen Protokollen

Hierin werden Konzepte offenbart, die es erlauben, zumindest teilweise Aspekte aus dem Stand der Technik zu verbessern. Insbesondere ergeben sich weitere Merkmale und deren Zweckmäßigkeiten aus der folgenden Beschreibung von Ausführungsformen anhand der Figuren. Von den Figuren zeigen:
- Fig. 1: schematisch ein beispielhaftes elektronisches Messgerät insbesondere zur Strommessung;
- Fig. 2: die wesentlichen Komponenten eines Gehäuses des in Fig. 1 gezeigten Messgeräts;
- Fig. 3: eine beispielhafte Umsetzung einer Schaltungsanordnung des in Fig. 1 gezeigten Messgeräts;
- Fig. 4: eine beispielhafte Einbindung der in Fig. 3 gezeigten Schaltungsanordnung unter Verwendung von sechs Stromwandlern und einem Energie-Manager in einem Blockschaltbild;
- Fig. 5: eine beispielhafte Schaltungsanordnung für das in Fig. 1 gezeigte Messgerät in einem Blockschaltbild;
- Fig. 6: eine beispielhafte Anordnung der Komponenten der Schaltungsanordnung für das in Fig. 1 gezeigte Messgerät auf einer Platinenanordnung aus Messplatine und Kommunikationsplatine;
- Fig. 7: ein beispielhaftes Isolationskonzept bei der Anordnung der Komponenten der Schaltungsanordnung gemäß Fig. 6;
- Fig. 8: ein zweigeteiltes Rastgehäuse;
- Fig. 9: ein beispielhaftes Formteil zur Sicherung einer verschlossenen Rastverbindung des in Fig. 8 dargestellten Rastgehäuses;
- Fig. 10: eine beispielhafte Anordnung des Formteils aus Fig. 8 bei einer Platinenanordnung gemäß Fig. 6;
- Fig. 11: eine Aufsicht auf eine Messplatine bei einer Anordnung des Formteils gemäß Fig. 10;
- Fig. 12: die Verwendung von Spannungsteilern für die Spannungsmessung mit einem Mess-Chip;
- Fig. 13: einen beispielhaften Aufbau eines Spannungsteilers zur Bereitstellung einer Spannung für einen Mess-Chip;
- Fig. 14: einen ersten beispielhaften Aufbau eines Spannungsteilers zur Bereitstellung der Spannungen für zwei Mess-Chips; und
- Fig. 15: einen zweiten beispielhaften Aufbau eines Spannungsteilers zur Bereitstellung von Spannungen an zwei Mess-Chips.

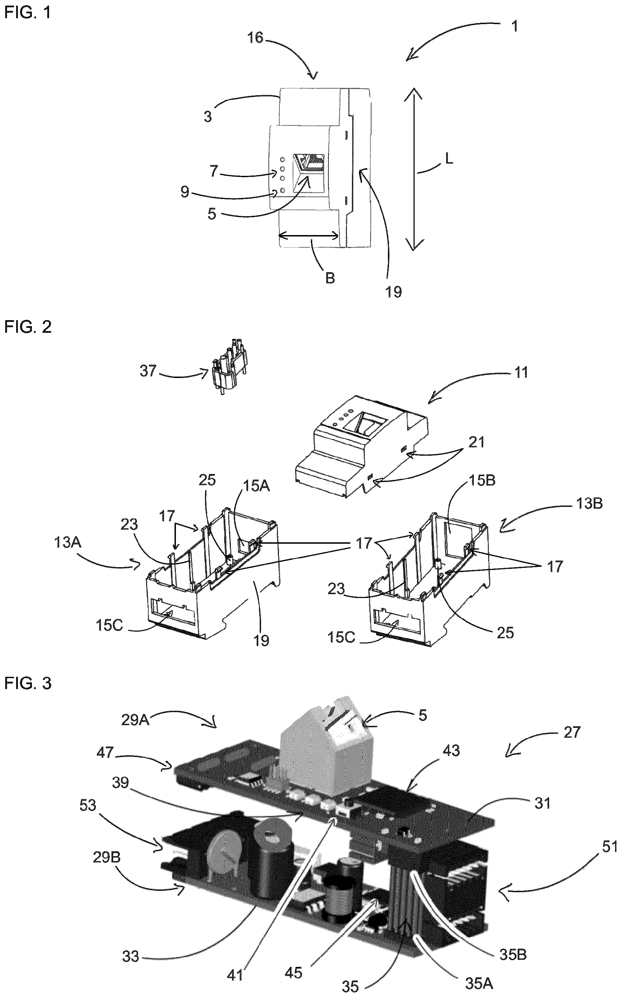

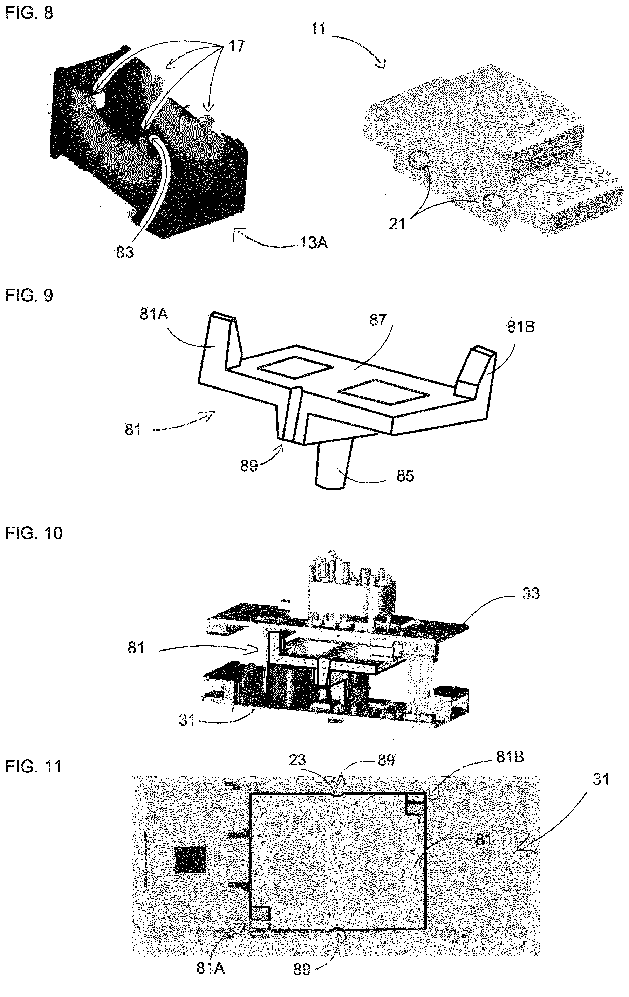

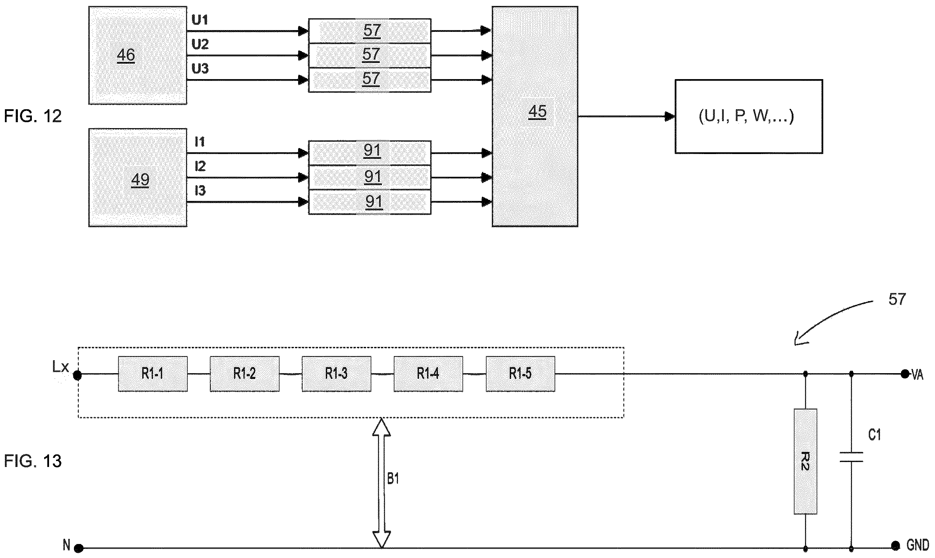

Im Zusammenhang mit den Figuren 1 bis 7 wird nachfolgend eine beispielhafte Ausführungsform für ein elektronisches Messgerät 1 zur Messung elektrischer Größen (hierin auch als Messgerät bezeichnet) beschrieben. Im Zusammenhang mit den Figuren 8 bis 11 wird ein Beispiel für eine Arretierung eines Rastgehäuses für z. B. das Gerät 1, allgemein für ein Elektrogerät, beschrieben. Im Zusammenhang mit den Figuren 12 bis 15 wird abschließend eine beispielhafte Ausführungsform für einen Spannungsteiler zur Bereitstellung von Spannungswerten für mehrere Mess-Chips in z. B. einem Elektrogerät wie dem Messgerät 1 beschrieben.

Fig. 1 zeigt das elektronische Messgerät 1. Es dient z. B. der Leistungsmessung von einem oder mehreren 1- bzw. 3-phasigen Verbrauchern/Erzeugern. Das elektronische Messgerät 1 ist beispielsweise auf einer Rückseite eines Gehäuses 3 für die Befestigung an einer Hutschiene (nicht gezeigt) vorbereitet und weist eine Breite B von zwei Teilungseinheiten (ca. 36 mm) und eine Länge L von100 mm auf. An einer Vorderseite (im montierten Zustand des Messgeräts 1 ist dies die einem Benutzer zugewandte Oberseite des Messgeräts 1) befindet sich eine LAN-Buchse 5 sowie Kontrollleuchten 7 (z. B. LED-Anzeigen) und ein Taster 9. Diese dienen als Benutzerschnittstellen, die den Betriebszustand kennzeichnen oder z. B. ein Rücksetzen durch den Benutzer ermöglichen.

Mit Blick auf eine mögliche aufgereihte Anordnung von mehreren Geräten entlang einer Hutschiene stellt das Messgerät 1 noch zwei Zugangsseiten bereit, die mit entsprechend Buchsen zum Anschließen von externe Stromwandler (nicht gezeigt) oder einer Spannungsversorgung versehen werden können.

Das Messgerät 1 umfasst in der in Fig. 2 beispielhaft im nicht-montierten Zustand gezeigten Ausführungsform ein zweigeteiltes Gehäuse mit zwei Schalen, hierin als Ober- und Unterschalen bezeichnet. So zeigt Fig. 2 eine Oberschale 11 sowie eine Unterschale 13A sowie eine alternative Unterschale 13B. Auf einer Zugangsseite 16 ist die Unterschale 13A mit einer Öffnung 15A für einen Stecker zur Leistungsmessung z. B. eines 3-phasigen Verbrauchers ausgestattet. Die Unterschale 13B ist mit einer größeren Öffnung 15B für zwei Stecker, die nebeneinander eingesteckt werden können und zur Leistungsmessung für z. B. zwei 3-phasige Verbraucher verwendet werden können, ausgestattet. Die Unterschale 13A bzw. 13B weist ferner eine Öffnung 15C für einen Spannungsanschluss auf.

Das Gehäuse 3 wird durch Zusammensetzen von Oberschale und Unterschale gebildet, wobei die Schalen über Rasthaken 17 zusammengehalten werden. Im Beispiel sind vier Rasthaken 17 an den Unterschalen 13A, 13B vorgesehen, je zwei an einer Längswand 19 der Unterschalen 13A, 13B. Allgemein können eine Mehrzahl von Rasthaken oder Rastschienen auf einer Schale vorgesehen werden, die in entsprechende Raststrukturen auf der anderen Schale eingreifen. In Fig. 2 rasten die Rasthaken 17 beispielsweise in Öffnungen 21 ein, die in der Oberschale 11 vorgesehen sind.

Die Schalen sind beispielsweise aus einem Polyamid (wie dem ULTRAMID_A3UG5 GREY 32201 POLYAMIDE) ausgebildet und weisen eine Wandstärke im Bereich von z. B. 0,75 mm bis 3 mm auf. Die Wandstärke der Schalen und insbesondere die Dicke der Rasthaken 17 ist derart ausgelegt, dass ein Verbiegen und Einrasten der Rasthaken 17 in die Öffnungen 21, insbesondere für ein leichtes Zusammenbauen des Gehäuses 3, möglich sind.

Ferner zeigt Fig. 2 Führungsschienen 23, die jeweils mittig in der Unterschale 13A bzw. 13B auf einer Innenseite der Längswand 19 vorgesehen sind, sowie Befestigungsdome25 in den Gehäuseecken zum Anschrauben von Platinen. Im nachfolgend erläuterten Beispiel wird je eine Platine in der Oberschale und eine Platine in der Unterschale eingeschraubt.

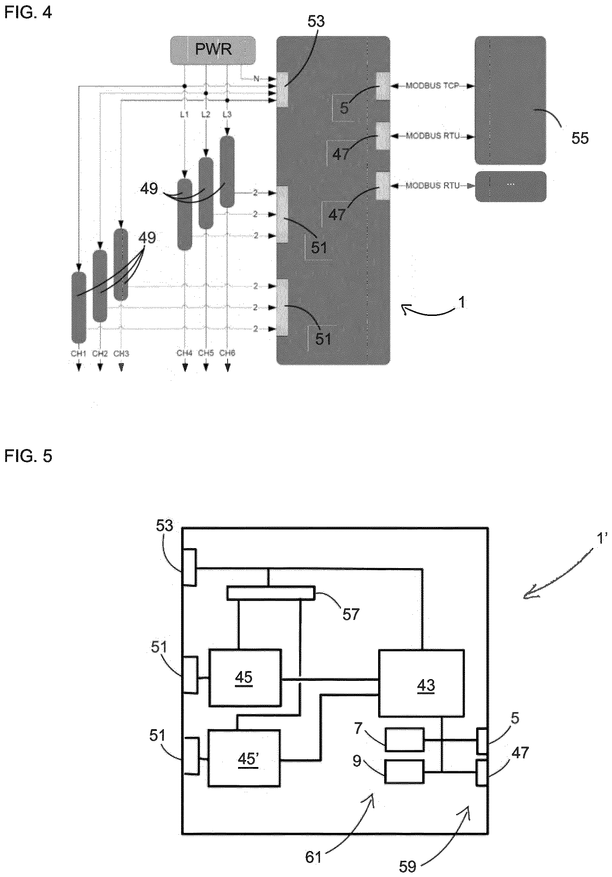

Für eine phasenspezifische Leistungsmessung werden externe Stromwandler (nicht gezeigt) an der Zugangsseite 16 (siehe Fig. 1) angeschlossen. Das Messgerät 1 umfasst im Inneren eine Schaltungsanordnung, die aufgrund der geringen räumlichen Ausmaße des vom Gehäuse 3 bereitgestellten Innenraums kompakt ausgeführt ist. Die Schaltungsanordnung ist dazu ausgebildet, mit den externen Stromwandler den Strom in den jeweiligen Phasen zu erfassen. Ferner ist die Schaltungsanordnung dazu ausgebildet, die zugehörige (Netz-) Spannung direkt über an die Netzspannungsquelle angebundene Spannungsteiler zu erfassen. Aus den so gemessenen Werten für den elektrischen Strom I und die elektrische Spannung U können im Wesentlichen in Echtzeit weitere elektrische Größen wie die elektrische Leistung P, die elektrische Scheinleistung S, die elektrische Blindleistung Q, die Netzfrequenz f usw. abgeleitet werden. Ein der Messung zugrundeliegendes zeitliches Messintervall kann z. B. im Bereich von 20 ms umgesetzt werden; ferner können einstellbare Messintervalle bei z. B. 20 ms, 100 ms, 200 ms, 500 ms oder 1000 ms liegen. Die ermittelten elektrischen Größen können anschließend in Echtzeit über Datenschnittstellen basierend auf Modbus RTU / TCP (LAN (Local Area Network)-Stecker 5) von einem Modbus-Master (z.B. einem Energie-Manager) abgefragt werden (siehe auch Fig. 4).

Fig. 3 zeigt eine beispielhafte Schaltungsanordnung 27 des in Fig. 1 gezeigten Messgeräts 1 unter Verwendung von zwei Baugruppen 29A, 29B, die jeweils mit einer Messplatine 33 bzw. einer Kommunikationsplatine 31 umgesetzt werden. Beide Baugruppen 29A, 29B sind jeweils über die Platinen in der Gehäuseober- und -unterschale z. B. mittels Schrauben oder Rasthaken fixiert. Im montierten Zustand, d.h., wenn die beiden Gehäuseschalen (oben, unten) aufeinander gerastet sind, werden die Baugruppen 29A, 29B mittels eines zweiteiligen Steckverbinders 35 verbunden.

Bezugnehmend auf Fig. 2 kann ein Lichtleiter-Stößel-Bauteil 37 mittels mehreren Lichtleitern dafür sorgen, dass Licht, das von auf der Kommunikationsplatine 31 angeordneten LEDs abgegeben wird, an der Geräteaußenseite der Oberschale 11 gut sichtbar ist. Ferner kann das Lichtleiter-Stößel-Bauteil 37 einen integrierten Stößel, der an einen Taster auf der Kommunikationsplatine 31 mechanisch ankoppelt, umfassen. (Siehe auch Fig. 10 zur Anordnung des Lichtleiter-Stößel-Bauteils 37 zwischen der Kommunikationsplatine 33 und der Oberschale 11.) Somit kann eine Nutzerschnittstelle zur Kommunikationsplatine 33 durch den Taster 9 sowie durch die LEDs - insbesondere drei Doppel-LEDs 39 (rot/grün) für den Betriebsstatus bereitgestellt werden. Insbesondere kann ein mit dem Taster 9 betätigbarer Pushbutton-IC 41 (siehe Fig. 3), je nach Länge des Tastendrucks, entsprechende Eingabesignale erzeugen. Beispielsweise kann das Messgerät 1 mit dem Taster 9 softwareunabhängig neu gestartet werden.

Zur Umsetzung der Messfunktion umfasst das Gerät mindestens zwei Mikrocontroller: einen Master Controller (Master Control Unit MCU, beispielsweise ein Mikrocontroller STM32F407) - hierin allgemein als Datenkommunikationschip 43 (siehe Fig. 3) bezeichnet - und mindestens einen Mess-IC (beispielsweise ein Metering-IC SY7M166HT) - hierin allgemein als Mess-Chip 45 bezeichnet. Der Datenkommunikationschip 43 dient in erster Linie der Datenausgabe. So ermöglicht der Datenkommunikationschip 43 eine Kommunikation mit einem übergeordneten System z. B. über Modbus RTU/TCP und stellt die Benutzer-Interaktion über die LEDs 39 und den Taster 9 zur Verfügung. Ausgehend vom Datenkommunikationschip 43 kann z. B. eine Netzwerkverbindung über TCP (LAN-Buchse 5) und eine serielle RS485-BUSverbindung (RTU-Klemme 47) bereitgestellt werden.

Fig. 4 verdeutlicht schematisch eine beispielhafte Einbindung des Messgeräts 1 in einem Gesamtsystem zur Überwachung von sechs Kanälen CH1, CH2, ... CH6. Entsprechende Messungen zur Bestimmung von elektrischen Größen erfolgen unter Verwendung von sechs Stromwandlern (Current Transformer CT) 49, die an CT-Anschlüsse 51 (mit je zwei Eingangspins) angeschlossen sind. Die Energieversorgung des Prüfgeräts 1 erfolgt z. B. über eine serielle RS485-Busverbindung, Netzspannung 46 (Spannungseingänge L1, L2, L3 der Außenleiter, N des Neutralleiters), wobei die Versorgungsspannung über einen Spannungsanschluss 53 dem Messgerät 1 zugeführt wird. Die interne Elektronik unterliegt beispielsweise einer internen Versorgung über die Spannungseingänge L1 und N. Über Modbus TCP oder RTU (eine LAN-Buchse 5, zwei RTU-Klemmen 47) kann ein Energie-Manager 55 die mit dem Messgerät 1 bestimmten Werte einlesen oder ein Nutzer kann eine Konfiguration des Messgeräts 1 vornehmen.

Fig. 5 verdeutlicht eine beispielhafte Schaltungsanordnung 1' für das Messgerät 1 in einem schematischen Blockschaltbild der verschiedenen Komponenten. Die Schaltungsanordnung 1' umfasst den Spannungsanschluss 53, einen mit dem Spannungsanschluss elektrisch verbundenen Spannungsteiler 57, mindestens einen CT-Anschluss 51 zum Anschließen mindestens eines externen Stromwandlers 49 (beispielsweise ein oder zwei CT-Anschlüsse), den mit dem Spannungsteiler 57 und dem (ersten) CT-Anschluss 51 elektrisch verbundenen ersten Mess-Chip 45 zum Bestimmen elektrischer Größen (Messung des Stroms für den angeschlossenen Stromwandler und der zugehörigen Spannung) und Ausgeben der elektrischen Größen (Messdaten und daraus abgeleitete Daten) an den Datenkommunikationschip 43 der Schaltungsanordnung 1', wobei der Datenkommunikationschip 43 vom ersten Mess-Chip 45 insbesondere galvanisch getrennt ist. Die Schaltungsanordnung 1' kann ferner mindestens einen mit dem Datenkommunikationschip 43 elektrisch verbundenen Datenanschluss 59 (z. B. LAN-Buchse 5 und/oder RTU-Klemmen 47) und mindestens eine mit dem Datenkommunikationschip elektrisch verbundene Benutzerschnittstelle 61 (z. B. Kontrollleuchte 7, oder Taster 9) umfassen.

Fig. 5 zeigt optional einen weiteren (zweiten) Mess-Chip 45', der wie Mess-Chip 45 zum Bestimmen elektrischer Größen und Ausgeben der elektrischen Größen (Messdaten und daraus abgeleitete Größen) an den Datenkommunikationschip 43 ausgebildet und in die Schaltungsanordnung 1' eingebunden ist (z. B. unter galvanischer Trennung vom Datenkommunikationschip 43). Insbesondere kann hierzu ein Spannungsteiler eingesetzt werden, wie er in Zusammenhang mit den Figuren 12 bis 15 erläutert wird.

Der Mess-Chip 45 kann z. B. als dedizierter Mess-IC für Strom-, Spannungs-, Leistungs- und Energiemessung ausgebildet sein, um die Messungen und die Berechnung der gemessenen Werte umsetzen und letztere an den Datenkommunikationschip 43 übergeben zu können. Je Mess-Chip 45 können z. B. bis zu drei Stromwandler angeschlossen werden.

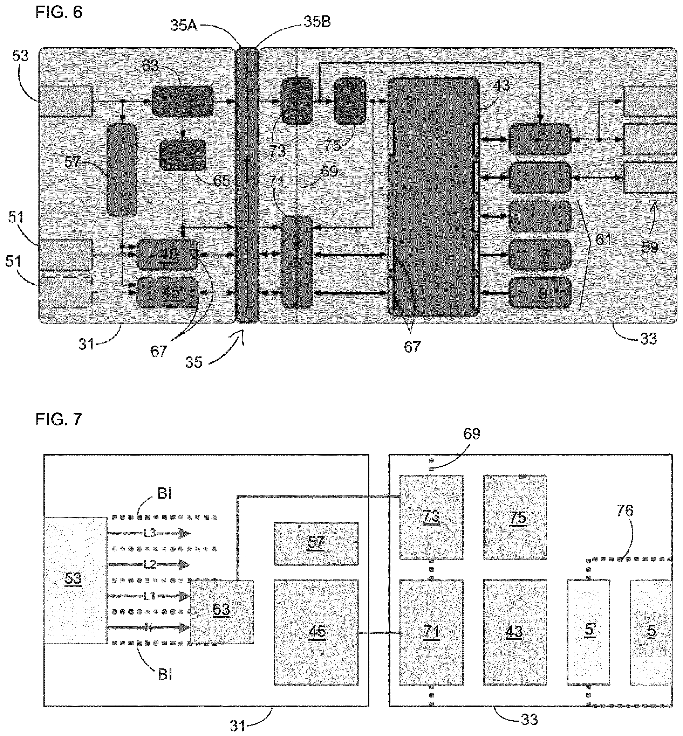

Fig. 6 verdeutlicht schematisch die Aufteilung der Schaltungsanordnung 1' auf der Messplatine 31 und der Kommunikationsplatine 33. Die Messplatine 31 ist z. B. mit dem Spannungsanschluss 53, dem Spannungsteiler 57, dem CT-Anschluss 51 (optional zwei oder mehr CT-Anschlüsse) bestückt. Ferner weist die Messplatine 31 den (ersten) Mess-Chip 45 und optional den zweiten oder weitere Mess-Chips 45' auf, die jeweils mit dem zugehörigen CT-Anschluss 51 und dem Spannungsteiler 57 elektrisch verbunden sind. Ein erster Teil 35A des Steckverbinders 35 ist zur elektrischen Kontaktierung der Kommunikationsplatine 33 (elektrische Steckverbindung) vorgesehen.

Die Spannungsversorgung kann ferner ein AC/DC-Netzteil 63 und einen Linearregler 65 zur Bereitstellung der DC-Spannung für den oder die Mess-Chips 45, 45' aufweisen.

Die Kommunikationsplatine 33 ist z. B. mit dem zweiten Teil 35B des Steckverbinders 35, dem Datenkommunikationschip 43, der zum Empfangen der Messdaten vom ersten Mess-Chip 45 über die Steckverbindung elektrisch verbunden ist, Datenanschlüsse(n) 59 und Benutzerschnittstelle(n) 61 bestückt.

Für die interne Kommunikation zwischen Datenkommunikationschip 43 und Mess-Chip 45 kann z. B. eine UART-Schnittstelle 67 mit einem internen Kommunikationsprotokoll für die Messapplikation verwendet werden. Da der Mess-Chip 45 im Primärkreis liegt (d. h., Spannungen im Bereich von einigen 100 V können vorliegen), ist es erforderlich den Datenkommunikationschip 43 galvanisch vom Mess-Chip 45, 45', beispielsweise zur UART-Schnittstelle 67 (siehe Fig. 5), zu trennen. In der vorliegenden Ausführungsform ist eine verstärkte Isolierung 69 (schematisch als gestrichelte Linie verdeutlicht) räumlich auf der Kommunikationsplatine 33 umgesetzt. Bezüglich des Datenaustauschs erfolgt dies z. B. durch einen Galvanic-Isolator 71 und bzgl. der Spannungsversorgung optional durch einen isolierten DC/DC-Isolator 73. Mit anderen Worten liegt der Mess-Chip 45 auf N-Potential, welches als Netzpotential betrachtet wird, sodass eine verstärkte Isolierung zum Datenkommunikationschip 43 und den Schnittstellen (Ethernet, RS485) notwendig wird. Dies wird (erfindungsgemäß für einen Aspekt) im vorliegenden Ausführungsbeispiel auf der Kommunikationsplatine 33 umgesetzt.

Auf der Kommunikationsplatine 33 können weitere DC/DC-Wandler 75 für die Spannungsversorgung des Datenkommunikationschips 43 vorgesehen sein.

Wie in Fig. 7 gezeigt verwendet das Messgerät 1 eine externe Eingangsspannung (z. B. Leitungen L, N) zur Versorgung des/der Mess-Chips 45 und des Datenkommunikationschips 43. Die Netzspannung wird mit dem AC/DC-Netzteil 63 in eine Spannung z. B. im Bereich kleiner 10 VDC gewandelt und über den Linearregler 65 (weitere Spannungsanpassung und aktive Filterung des Spannungssignals) an den oder die Mess-Chips 45 weitergegeben (siehe Fig. 6). Über den auf der Kommunikationsplatine 33 angeordneten isolierten DC/DC-Isolator 73 wird die Spannung an die Sekundärseite, hier die Bauelemente zur Kommunikation übertragen, und versorgt beispielsweise direkt den RS-485-Transceiver bzw. ergänzend durch einen DC/DC-Wandler 75 geregelt die übrigen Peripherie-Bauelemente wie den Datenkommunikationschip 43 mit z. B. 3,3 VDC.

Somit ist das AC/DC-Netzteil 63 einerseits mit dem Spannungsanschluss elektrisch verbunden. Andererseits ist es zur Spannungsversorgung des ersten/zweiten Mess-Chips 45, 45', über den Linearregler 65 mit den Mess-Chips 45, 45' elektrisch verbunden. Zur Spannungsversorgung des Datenkommunikationschips 43 ist das AC/DC-Netzteil 63 ferner über die elektrische Steckverbindung 35 und dem auf der Kommunikationsplatine 33 angeordneten DC/DC-Isolator 73 - galvanisch isoliert und insbesondere über den DC/DC-Wandler 75 zur Spannungsreduzierung - mit dem Datenkommunikationschip elektrisch verbunden.

Fig. 7 fasst beispielhaft die Isolationskonzepte zusammen und verdeutlicht schematisch auf der Messplatine 31 eine Basisisolation BI zwischen den Außen-/Neutralleitern/Phasen. Die bereits erläuterte verstärkte Isolierung 69 wird auf der Kommunikationsplatine 33 umgesetzt, ebenso wie eine Isolierung 76 zum Ethernet.

Neben der Versorgung der Bauteile der Schaltungsanordnung nutzt das Messgerät 1 die Eingangsspannung auch zur Messung der Spannung, die einer Strommessung mit dem Stromwandler 49 zuzuordnen ist. Für die Spanungsmessung ist eine ausreichende Spannungsfestigkeit zwischen Leitern L1, L2, ... und Neutralleiter N notwendig. Diese wird mithilfe des Spannungsteilers 57 erreicht. Der Spannungsteiler 57 umfasst hierzu bevorzugt kostengünstig eine Reihenschaltung von mehreren, z. B. fünf, Standardwiderständen von jeweils einigen 100 kS2. Bei zwei oder mehr Mess-ICs wird der Spannungsteiler bevorzugt angepasst, um eine gegenseitige Beeinflussung der Analog Digital Converter ADCs der Mess-Chips zu vermeiden bzw. zu vermindern. Insbesondere kann zwischen dem letzten Widerstand und dem Anschlusspin des Mess-Chips eine Tiefpassfunktion vorgesehen sein, sodass sich z. B. ein Abschluss-Kondensator bevorzugt direkt am Anschlusspin des Mess-Chips befindet. Siehe hierzu auch die Erläuterungen zu den Figuren 12 bis 15.

Ein weiterer hierin und insbesondere in Zusammenhang mit den Figuren 8 bis 11 offenbarter Aspekt betrifft ein Verhindern oder zumindest erschweren des Öffnens eines Gehäuses, welches aus zwei Gehäuseschalen besteht, die mittels einer Rastverbindung verbunden sind. Insbesondere wird hierzu ein Verstärkungselement, hierin als Formteil 81 bezeichnet, in einem Gehäuseinneren 83 des Gehäuses 3 vorgesehen, dass die Rastverbindung zusätzlich arretiert.

Wie in Fig. 8 durch Pfeile verdeutlicht lässt sich bei einer wie in Zusammenhang mit Fig. 2 erläuterten Rastverbindung das Gehäuse 3, insbesondere die Unterschale 13A, durch auf die Seitenwände einwirkende Kräfte so verformen, dass die Rasthaken 17 der Unterschale 13A nach Innen wandern und so aus der eingerasteten Position bewegt werden. Rasten die Rasthaken 17 im gezeigten Fall nicht mehr in den Öffnungen 21 der Oberschale 11 (des anderen Gehäuseteils) ein, lässt sich das Gehäuse 3 öffnen.

Um ein Lösen der Rastverbindung zu vermeiden, bzw. zumindest zu erschweren, kann bei Stand der Technik-Gehäusen eine größere Wandstärke vorgesehen werden, wodurch die seitlichen Kräfte vom Gehäuse aufgenommen werden und eine Verformung des Gehäuses verhindert wird, oder es kann ein Rasthaken in einer Lasche eingeführt und somit beidseitig gehalten werden, wodurch ein Entrasten unterbunden wird.

Beide zuvor genannten Ansätze reduzieren einen für eine Elektronik zu Verfügung stehenden Innenraum im Gehäuse. Insbesondere das Vorsehen einer Lasche kann eine rechteckige im Innenraum zu Verfügung stehende Grundform für eine Platine lokal einschränken, sodass eine kleinere Platine oder eine lokale Überarbeitung der Form der Platine erforderlich wird. Überdies wird die Formung des Gehäuses aufgrund der Ausbildung der Lasche aufwändiger, was gerade bei elektronischen Kleinstgeräten wie Hutschienen-Geräten hinsichtlich geringzuhaltender Kosten nachteilig ist.

In einem weiteren erfindungsgemäßen Konzept wird nun ein Formkörper in einem Gehäuse eines Elektrogeräts positioniert, der einen oder mehrere Gegenhalter - hierin als Blockade-Elemente bezeichnet - zur Aufnahme von seitlichen Druckkräften im Gehäuseinneren 83 auf die Rasthaken 17 ausbildet. Die Unterstützung der Rasthaken 17 durch die Gegenhalter von Innen verhindert zusätzlich ein Öffnen mittels eines Werkzeugs, mit dem die Rasthaken nach innen gedrückt werden können. Somit kann ein Ausrasten zumindest erschwert und möglichst ein Lösen der Gehäuseschalen vermieden werden.

Fig. 9 zeigt einen beispielhaften Formkörper 81, der an das zweiteilige Gehäuse aus Fig. 2 bzw. Fig. 8 angepasst ist und im eingebauten Zustand die Rasthaken 17 unterstützt, insbesondere eine Bewegbarkeit der Rasthaken nach Innen einschränkt, bevorzugt verhindert. Das Formteil 81 bildet im "oberen Bereich" zwei diagonal zueinander angeordnete Blockade-Elemente 81A, 81B aus. Die Blockade-Elemente 81A, 81B sind im eingebauten Zustand derart ausgebildet und zu je einem Rasthaken 17 angeordnet, dass einem Ausrasten der Rastverbindung, insbesondere einem Verformen des Rasthaken 17 in Richtung eines Gehäuseinneren 83, entgegengewirkt wird. Diese Ausbildung richtet sich beispielhaft auf eine Rastverbindung, die auf gegenüberliegenden Seiten eines Gehäuses angeordnete Rasthaken 17 aufweist. Das Formteil 81 ist hier beispielhaft derart ausgebildet, dass es einem Ausrasten mindestens eines der Rasthacken 17 auf jeder Seite des Gehäuses 3 entgegenwirkt.

Überdies kann der Formkörper als Abstandshalter fungieren und das Vorliegen eines garantierten Mindestabstands - einen Sicherheitsabstand - sicherstellen. Fig. 10 verdeutlicht dies für eine beispielhafte Umsetzung eines Elektrogeräts - hier eine Ausführungsform des Messgeräts - mit zwei versetzt zu einander angeordneten Platinen. Das Formteil 81 ist derart ausgebildet, dass es im eingebauten Zustand einen Mindestabstand zwischen den Platinen, hier der Messplatine 31 und der Kommunikationsplatine 33, bereitstellt. Das Formteil 81 gewährleistet den Mindestabstand insbesondere auch bei Versagen der (Schraub-)Verbindung eines oder beider der Platinen zur jeweiligen Schale. Beispielsweise umfasst das Formteil 81 mindestens einen Standfuß 85, der insbesondere im eingebauten Zustand in einem nicht-bestückten Bereich der Messplatine 31 angeordnet ist und dessen Länge insbesondere eine Position des mindestens einen Blockade-Elements 81A, 81B im Gehäuseinneren 83, und insbesondere den Mindestabstand zwischen den Platinen, bestimmt.

Der inhärente Sicherheitsabstand kann zusätzlichen Schutz bei Vorliegen von Hochspannung im Gehäuse 3 bewirken. Beispielsweise kann eine Höhe des Gegenhalters 81A, 81B so hoch ausgeführt werden, dass der Formkörper 81 an einer, beispielsweise der oberen, Platine anschlägt. Der Standfuß 85 kann für eine Abstützung auf der anderen Platine in einem freien Bereich aufsetzten. Der Formkörper 81 kann so zusätzlich sicherstellen, dass beide Platinen einen garantierten Mindestabstand haben und damit Luftstrecken zwischen Platinen mit unterschiedlichen Spannungen selbst beim Versagen der Schraubverbindungen oder der Befestigungsdome 25 sichergestellt sind.

Ferner zeigt Fig. 9 einen flächig ausgebildeten Strukturabschnitt 87 des Formteils, der die Blockade-Elemente 81A, 81B räumlich zu den ihnen zugeordneten Rasthaken 17 positioniert. Bevorzugt sind auch die Blockade-Elemente 81A, 81B im eingebauten Zustand in einem nicht-bestückten Bereich der Kommunikationsplatine 33 angeordnet.

Bevorzugt wird das Formteil 81 aus einem ausreichend elektrisch isolierenden Material ausgebildet.

Bevorzugt kann der Formkörper entlang einer Nut im Gehäuse geführt und positioniert werden, und so beispielsweise keine Bewegung des Formteils quer zur Richtung der Nut erlauben. Beispielsweise kann das Formteil 81 und mindestens eine der Schalen ein Führungssystem ausbilden, das zum Positionieren des Formteils 81 beim Zusammenbau des Messgeräts 1 und/oder zum Halten des Formteils 81 im eingebauten Zustand ausgebildet ist. Das Führungssystem kann insbesondere eine Führungsschiene 23, insbesondere eine Nut, auf einer Innenwand einer der Schalen oder am Formteil 81 und ein entsprechend in die Führungsschiene 23, insbesondere in die Nut, eingreifendes Gegenstück 89 am Formteil 81 oder auf der Innenwand einer der Schalen umfassen.

Der Formkörper 81 kann je nach Bestückung der Platinen allgemein derart geometrisch ausgebildet werden, dass ein Bauraum zwischen den beiden Platine nur wenig reduziert oder möglichst nicht nachteilig eingeschränkt wird.

Der Formkörper 81 kann bei Bedarf eingesetzt werden (kein Öffnen mehr möglich) oder weggelassen werden (Zugang zum Gehäuseinneren bleibt mit Werkzeug erlaubt). Mit anderen Worten kann je nachdem, ob in einem Vertriebsgebiet ein erhöhter Öffnungsschutz gefordert wird, der Formkörper 81 eingesetzt werden oder nicht. Insbesondere können durch die Verwendung des Formkörpers 81 beispielsweise Anforderungen der UL2808 / UL 61010-1 erfüllt werden.

Vorteile im Vergleich zu Gehäuse mit höheren Wandstärken sind eine bessere Nutzung des internen Bauraums, welche durch eine geringe Wandungsstärken des Gehäuses möglich wird. Ferner ist durch Aufnahme seitlicher Druckkräfte durch den Formkörper kein "Verformen" des Gehäuses mehr möglich

Vorteile im Vergleich zu Lösung mittels Rasthaken in Laschen sind eine Unterstützung der Rasthaken durch den separaten modularen Formkörper, sodass diese nicht mehr ausgerastet werden können, eine einfachere Konstruktion des Gehäuses ohne Laschen sowie die Gewinnung von Bauraum auf der Baugruppe durch den Verzicht auf die Laschen.

Hinsichtlich eines weiteren erfindungsgemäßen Konzepts wird in Zusammenhang mit den Figuren 12 bis 15 eine erfinderische elektronische Schaltung zum Herunterteilen und Filtern, hierin als Spannungsteiler bezeichnet, beschrieben. Insbesondere betrifft dieser Aspekt ein Konzept für eine platzsparende Schaltung zum Messen von Netzspannungen für zwei oder mehr Mess-Chips 45, 45`. Für eine Messung z.B. der Wirkleistung eines Wechselspannungsverbrauchers sind Spannung und Strom synchronisiert zu messen und die Effektivwerte in Echtzeit zu berechnen. Verwendet werden hierzu kommerzielle Mess-ICs, die meist maximal 3 Spannungs- und 3 (max. 4) Stromeingänge aufweisen.

Fig. 12 zeigt eine bespielhafte Beschaltung eines Mess-Chips 45 mit drei Eingängen für Spannung U1, U2, U3 (abgeleitet von der Netzspannung 46) und drei Eingänge für Strom I1, I2, I3 (ausgegeben von Messpulen). Zur Spannungsbereitstellung für den Mess-Chip 45 wird für jeden Außenleiter (Phase) ein separater Spannungsteiler 57 eingesetzt, der die Netzspannung soweit herunter teilt, dass diese von z. B. einem AD-Wandler im Mess-Chip 45 verarbeitet werden kann. Die Mesströme werden z. B. jeweils über eine Eingangsbeschaltung 91 dem Mess-Chip 45 zugeführt. Im Rahmen einer synchronen Analog-Digital-Wandlung der Strom- und Spannungswerte werden aus den Strom- und Spannungswerten im Mess-Chip 45 Messwerte U, I, P, W, ... abgeleitet. Dies ermöglicht eine Echtzeitberechnung des Effektiv-Wertes für Strom, Spannung, Leistung, Energie etc. für alle drei Phasen eines Verbrauchers oder Erzeugers. Die Messwerte werden anschließend über die Schnittstellen des Gerätes bereitgestellt.

Wie in Fig. 13 für einen exemplarischen Außenleiter (Spannungseingang Lx, z. B. L1, L2 oder L3) gezeigt wird, können die Spannungsteiler 57 beispielsweise aus einer Reihenschaltung von Standardwiderständen R1-1, R1-2...R1-5 - allgemein R1-n - mit einem Gesamtwiderstand R1 der Reihenschaltung (im Bereich von 1 ... 10 MS2) bestehen, da die Spannungsfestigkeit jeweils eines einzelnen Widerstandes begrenzt ist. Ausgehend von einer Spannungsfestigkeit der Standardwiderstände von jeweils ca. 200 V, ergibt sich im Beispiel von fünf Widerständen eine Spanungsfestigkeit der Widerstandsreihe von 5x 200 V = 1000 V. Auf den Einsatz von speziellen Hochspannungswiderstanden wird üblicherweise verzichtet, da diese deutlich teurer sind und oft schlechtere Eigenschaften bzgl. Temperaturkoeffizient, Genauigkeit und Drift aufweisen.

Eine abschließende Schaltung aus einem Widerstand R2 (im Bereich von 100 Ω ... 5 kS2) und einem Kondensator C2 (im Bereich von 500 pF ... 10 nF) kann zwischen dem Außenleiter und dem Neutralleiter N ausgebildet sein.

R1, R2 und C1 können insbesondere einen RC-Filter als Tiefpass bilden. Die Beschaltung wird beispielsweise so gewählt, dass die Grenzfrequenz des Tiefpasses ausreichend hoch ist und damit der Tiefpass bei der Nutzfrequenz von z.B. 50/60Hz inkl. fünf Oberschwingungen eine zu vernachlässigende Dämpfung aufweist und gleichzeitig bei der Sampling Rate ausreichend stark dämpft (Aliasing-Filter). Dabei sollte der Kondensator C1 nicht zu groß sein, da ansonsten der Spannungsteiler R1/R2 frequenzabhängig belastet werden könnte. Der Kondensator C1 kann überdies bevorzugt als Pufferspeicher für den Eingang ausgelegt sein.

Ferner ist in Fig. 13 eine notwendige Basisisolierung B1 angedeutet, die zwischen den Widerständen der Reihenschaltung und dem Neutralleiter N ein Durchschlagen bei transienten Überspannungen verhindert.

Die Spannungsteilung (R1/R2) reduziert die Eingangsspannung von z. B. 230 V auf Spannungen kleiner 1 V, die an den Anschlüssen VA und GND zur Verbindung mit dem Mess-Chip 45 vorliegen.

Wie bereits in den vorausgehend beschriebenen Ausführungsbeispielen des Messgeräts 1 angesprochen wurde, bestehen Anwendungsszenarien, in denen mehr als drei einphasige Verbraucher oder mehr als ein dreiphasiger Verbraucher oder Erzeuger zu messen sind, sodass auch bevorzugt zwei oder mehr Mess-Chips in einem Messgerät 1 eingesetzt werden können.

Ein Schaltungsaufbau, bei dem eine wie in Fig. 13 gezeigte Reihenschaltung gemeinsam genutzt wird, stellt keine oder zumindest eine nachteilige Umsetzung für die Spannungsteilung dar, da sich die Kanäle CH1.ADC den CH2.ADC von beispielsweise zwei nicht synchronisierten Mess-Chips gegenseitig beim Messvorgang und Schließen/Öffnen eines Schalters beim Sample-Vorgang beeinflussen.

Ferner könnte der in Fig. 13 gezeigte Aufbau der Reihenschaltung dupliziert, allgemein für jeden Mess-Chip eingesetzt werden. Zwar könnte der Spannungsanschluss 53 für die Spannung gemeinsam genutzt werden, jedoch müsste jeder der Spannungsteiler zum Neutralleiter N basisisoliert ausgeführt werden. Dies erfordert mehr Platz und hätte ferner den Nachteil, dass sich die Bauteilanzahl im Wesentlichen verdoppelt.

Das nachfolgend erläuterte erfinderische Konzept der vorliegenden Offenbarung zum Spannungsteiler 57 bewirkt - im Vergleich zur Duplizierung - eine Reduzierung des benötigten Platzes, eine geringere Anzahl von Bauteilen.

Ein entsprechendes Messgerät weist somit einen Spannungsteiler 57 zum Abgeben von reduzierten Spannungen an mindestens zwei Mess-Chips 45, 45' für die Messung von elektrischen Größen mittels zwei an die jeweiligen Mess-Chips 45, 45' angeschlossenen externen Stromwandlern 49 auf.

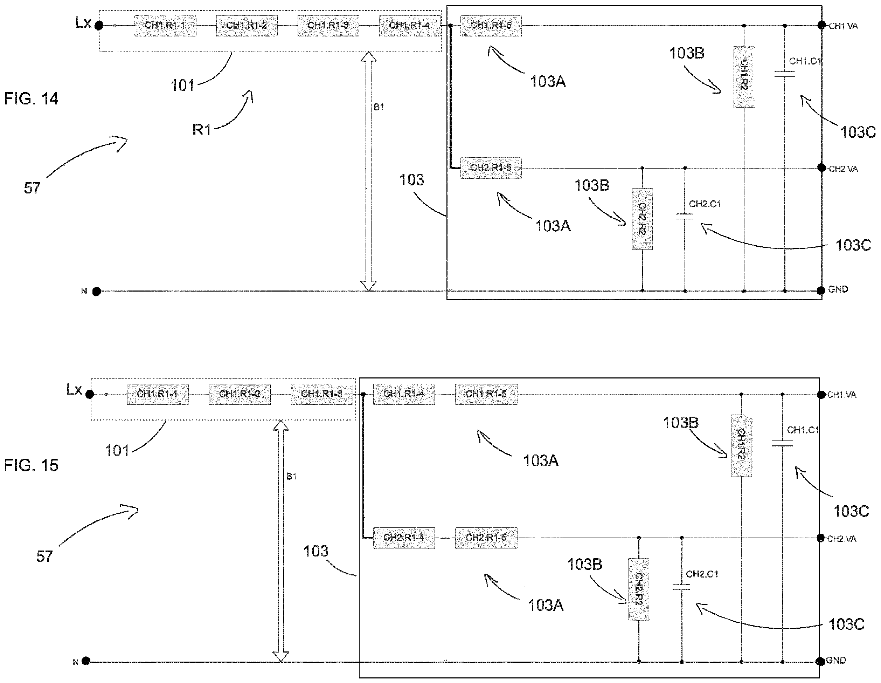

Allgemein kann der Spannungsteiler 57 Spannungen an den ersten Mess-Chip 45 und den zweiten Mess-Chip 45 abgeben, wobei er an einem Spannungseingang Lx die Eingangsspannung vom Spannungsanschluss 53 aufnimmt und für jeden der Mess-Chips 45, 45' an einem Spannungsausgang CH1-VA, CH2-VA eine reduzierte Spannung ausgibt. Er umfasst für insbesondere eine Spannungsteilung mit Tiefpassfunktion zwei (oder mehr) unabhängige, entkoppelte Ausgänge. Der beispielhafte Schaltungsaufbau des Spannungsteilers 57 in Fig. 14 zeigt einen mit dem Spannungseingang Lx elektrisch verbundenen Widerstandsreihenabschnitt 101. Dieser umfasst mehrere in Reihe geschaltete Widerstände R1-1, R1-2..., R1-4, die zum Spannungsabfall für jeden der Mess-Chips 45, 45'/Spannungsausgänge beitragen. Ferner zeigt Fig. 14 einen mit einem letzten Widerstand R1-4 der Widerstände des Widerstandsreihenabschnitts 101 elektrisch verbundenen Parallelschaltungsabschnitt 103. Dieser umfasst für jeden Spannungsausgang CH1.VA, CH2.VA einen, die in Reihe geschaltete Widerstände des Widerstandsreihenabschnitts 101 erweiternden und mit jeweils einem Spannungsausgang CH1.VA, CH2.VA elektrisch verbundenen, ersten Widerstandsabschnitt 103A (Im Beispiel der Fig. 14 ist dies ein Widerstand CH1.R1-5, CH2.R1-5.) einen den jeweiligen Spannungsausgang CH1.VA, CH2.VA und den Neutralleiter N elektrisch verbindenden zweiten Widerstandsabschnitt 103B (Im Beispiel der Fig. 14 ist dies ein Widerstand CH1.R2, CH2.R2.) und einen den jeweiligen Spannungsausgang CH1.VA, CH2.VA und den Neutralleiter N elektrisch verbindenden Kondensatorabschnitt 103C (Im Beispiel der Fig. 14 ist dies ein Kondensator CH1.C1, CH2.C1.).

Erfindungsgemäß werden nur die ersten Widerstände CH1.R1-1 ... CH1.R1-4 für beide Mess-Chips 45,45', d. h., für beide Messkanäle CH1, CH2 zu einem Außenleiter (Phase) genutzt. Fig. 14 zeigt einen beispielhaften Aufbau eines für zwei Mess-ICs gemeinsam genutzten Spannungsteilers 57 für einen Spannungseingang Lx (z. B. L1, L2 oder L3), bei dem der letzte Widerstand der Reihenschaltung aus Fig. 13 doppelt ausgeführt ist - hier die Widerstände CH1.R1-5, CH2.R1-5. Die Reihenschaltung aus den Widerständen CH1.R1-1,... CH1.R1-4 wird in einer Parallelschaltung jeweils über einen der Widerstände CH1.R1-5, CH2.R1-5 mit dem Anschluss CH1.VA für den Mess-Chips 45 und dem Anschluss CH2.VA für den Mess-Chip 45' elektrisch verbunden. Damit der Spannungsteiler 57 im Vergleich mit Fig. 13 vergleichbare Eigenschaften aufweist, können die Widerstandswerte von CH1.R1-1... CH1.R1-4 bevorzugt halbiert werden, da auch die Widerstände und Kondensatoren CH1.R2, CH1.C1 und CH2.R2, CH1.C1 einen Teil der Parallelschaltung bilden.

Der Spannungsteiler 57 reduziert die Eingangsspannung - üblicherweise in einem Bereich von 200 V bis 1000 V - in einen Messpannungsbereich - üblicherweise kleiner 3 V. Z. B. können die Widerstände des Widerstandsreihenabschnitts 101 einen Gesamtwiderstand R1 in einen Bereich von 500 kS2 bis 1 MS2 ausbilden. Zusammen mit den Widerständen CH1.R2, CH2.R2 des jeweiligen R/C-Glieds 105 in einem Bereich von 100 Ω bis 10 kS2 wird die erforderliche Spannungsteilung bewirkt. Zugleich können die in Reihe geschalteten Widerstände des Widerstandsreihenabschnitts 101 erweiternden, Widerstände CH1.R1-5, CH2.R1-5 des Parallelschaltungsabschnitt 103 eine ausreichende Entkopplung zwischen den Spannungsausgängen CH1.VA, CH2.VA bewirken.

Fig. 15 zeigt einen weiteren beispielhaften Aufbau eines für zwei Mess-Chips gemeinsam genutzten Spannungsteilers 57, bei dem die letzten beiden Widerstände CH1.R1-4 und CH1.R1-5 der Reihenschaltung 101 der Fig. 12 doppelt ausgeführt werden und jeweils den Widerstandsabschnitt 103A für die Spannungsausgänge CH1.VA, CH2.VA bilden, wodurch die Beeinflussung der beiden Kanäle an den Anschlüssen CH1.VA und CH2.VA weiter verringert werden kann. So erkennt man in Fig. 15, dass der Abgriff für den Parallelschaltungsabschnitt 103 bereits zwischen CH1.R1-3 und CH1.R1-4 erfolgt. In diesem Fall wird - im Vergleich zur Fig. 14 - ein zusätzlicher Widerstand CH2.R1-4 in der Schaltungsanordnung benötigt; eine Basisisolierung zum Parallelschaltungsabschnitt 103 wird größer, da die Spannungen am Eingang zu den Widerständen CH1.R1-4 und CH2.R1-4 der Widerstandsabschnitte 103A erhöht ist.

Im Speziellen zeigt Fig. 15 einen Spannungsteiler mit einem Spannungseingang Lx zum Aufnehmen einer Netzspannung, einem Spannungsausgang CH1-VA, CH2-VA für jeden von mindestens zwei Mess-Chips 45, 45' zum Abgeben einer reduzierten Spannung an einen der mindestens zwei Mess-Chips 45, 45', einem mit dem Spannungseingang Lx elektrisch verbundenen Widerstandsreihenabschnitt 101 umfassend mehrere in Reihe geschaltete Widerstände R1-1, R1-2..., R1-3, die zum Spannungsabfall für jeden der mindestens zwei Mess-Chips 45, 45' beitragen, und einem mit einem letzten Widerstand R1-3 der Widerstände des Widerstandsreihenabschnitts 101 elektrisch verbundenen Parallelschaltungsabschnitt 103.

Der Parallelschaltungsabschnitt 103 umfasst, für jeden der mindestens zwei Mess-Chips 45, 45' zwei in Reihe geschaltete, die in Reihe geschaltete Widerstände des Widerstandsreihenabschnitts 101 erweiternde und mit jeweils einem Spannungsausgang CH1.VA, CH2.VA elektrisch verbundene Widerstände CH1.R1-4, CH1.R1-5 bzw. CH2.R1-4, CH2.R1-5).

Wie in Verbindung mit Fig. 14 beschrieben umfasst der in Fig. 15 gezeigte Parallelschaltungsabschnitt 103 für jeden Spannungsausgang CH1.VA, CH2.VA einen den jeweiligen Spannungsausgang CH1.VA, CH2.VA und einem Neutralleiter (N) elektrisch verbindenden Widerstand CH1.R2, CH2.R2 und einen den jeweiligen Spannungsausgang CH1.VA, CH2.VA und den Neutralleiter N elektrisch verbindenden Kondensator CH1.C1, CH2.C1.

Bei Messgeräten für die Wirkleistung und -energie mit mehr als drei Stromeingängen umfassen Vorteile des erfinderischen Spannungsteilers eine überwiegende kombinierte Nutzung der Komponenten für beide Spannungsteilungen und insbesondere eine gemeinsame Nutzung von Widerstände R1-1 bis R1-4 in der Ausführungsform der Fig. 14 und der Widerstände R1-1 bis R1-3 in der Ausführungsform der Fig. 15. Dies führt aufgrund der weniger benötigten Bauteile zu einem geringeren Platzbedarf auf der Messplatine, wodurch kleine Messgeräte bzw. Messgeräte, welche z. B. mehrere Verbraucher messen können, ermöglicht werden. Allgemein ergeben sich somit kostengünstigere Messgeräte.

Es wird erkannt werden, dass die Anzahl und die Widerstandsgrößen der Widerstände im Widerstandsreihenabschnitt 101 und im Parallelschaltungsabschnitt 103, insbesondere in Reihenschaltungen des ersten und/oder zweiten Widerstandsabschnitts für den jeweils benötigten Spannungsabfall ausgewählt werden können.

Es wird explizit betont, dass alle in der Beschreibung und/oder den Ansprüchen offenbarten Merkmale als getrennt und unabhängig voneinander zum Zweck der ursprünglichen Offenbarung ebenso wie zum Zweck des Einschränkens der beanspruchten Erfindung unabhängig von den Merkmalskombinationen in den Ausführungsformen und/oder den Ansprüchen angesehen werden sollen. Es wird explizit festgehalten, dass alle Bereichsangaben oder Angaben von Gruppen von Einheiten jeden möglichen Zwischenwert oder Untergruppe von Einheiten zum Zweck der ursprünglichen Offenbarung ebenso wie zum Zweck des Einschränkens der beanspruchten Erfindung offenbaren, insbesondere auch als Grenze einer Bereichsangabe.

## Patentansprüche

1. Messgerät (1) für elektrische Größen mit:
einem Gehäuse (3),
einer Messplatine (31) und einer Kommunikationsplatine (33), die in dem Gehäuse (3) versetzt übereinander angeordnet sind,
wobei die Messplatine (31) bestückt ist mit
- einem Spannungsanschluss (53),
- einem mit dem Spannungsanschluss elektrisch verbundenen Spannungsteiler (57),
- mindestens einem ersten CT-Anschluss (51) zum Anschließen mindestens eines externen Stromwandlers (49),
- einem mit dem Spannungsteiler (57) und dem ersten CT-Anschluss (51) elektrisch verbundenen ersten Mess-Chip (45) zum Bestimmen der elektrischen Größen und zum Ausgeben der elektrischen Größen als Messdaten an einen ersten Teil (35A) eines Steckverbinders (35), und
wobei die Kommunikationsplatine (33) bestückt ist mit
- einem zweiten Teil (35B) des Steckverbinders (35), der zusammen mit dem ersten Teil (35A) eine elektrische Steckverbindung zwischen der Kommunikationsplatine (33) und der Messplatine (31) bewirkt,
- einem Datenkommunikationschip (43), der zum Empfangen der Messdaten vom ersten Mess-Chip (45) mit dem zweiten Teil (35B) elektrisch verbunden und galvanisch getrennt ist, wobei eine galvanische Trennung zwischen dem ersten Mess-Chip (45) und dem Datenkommunikationschip (43) auf der Kommunikationsplatine (33) vorgesehen ist,
- mindestens einem mit dem Datenkommunikationschip (43) elektrisch verbundenen Datenanschluss (59) und
- mindestens einer mit dem Datenkommunikationschip elektrisch verbundenen Benutzerschnittstelle (61).

2. Messgerät (1) nach Anspruch 1, wobei die Messplatine (31) ferner bestückt ist mit einem AC/DC-Netzteil (63), das
- mit dem Spannungsanschluss elektrisch verbunden ist,
- zur Spannungsversorgung des ersten Mess-Chips (45), insbesondere über einen Linearregler (65), mit dem ersten Mess-Chip (45) elektrisch verbunden ist und
- zur Spannungsversorgung des Datenkommunikationschips (43) über die elektrische Steckverbindung (35) und einem auf der Kommunikationsplatine (33) angeordneten DC-Isolationselement (73) galvanisch isoliert, insbesondere über ein DC/DC-Element (75) zur Spannungsreduzierung, mit dem Datenkommunikationschip (43) elektrisch verbunden ist.

3. Messgerät (1) nach Anspruch 1 oder 2, wobei
der mindestens eine Datenanschluss (59) einen Ethernet-Anschluss und/oder einen RS485-Anschluss umfasst und/oder
die mindestens eine Benutzerschnittstelle (61) eine LED-Anzeige (39) und/oder einen Taster (9) umfasst.

4. Messgerät (1) nach einem der vorhergehenden Ansprüche, wobei das Gehäuse (3) als zweigeteiltes Gehäuse eine erste Schale (13A, 13B) und eine zweite Schale (11) umfasst,
wobei die Messplatine (31) in der ersten Schale (13A, 13B) und die Kommunikationsplatine (33) in der zweiten Schale (11), jeweils insbesondere über eine Schraubverbindung, befestigt sind und
wobei die Steckverbindung (35) insbesondere durch Zusammensetzen der ersten Schale (13A, 13B) und der zweiten Schale (11) zur Ausbildung des Gehäuses (3) bewirkt ist.

5. Messgerät (1) nach Anspruch 4, wobei das Gehäuse (3)
- eine Rastverbindung zum mechanischen Verbinden der ersten Schale (13A, 13B) mit der zweiten Schale (11) aufweist und/oder
- Öffnungen (15A, 15B, 15C), insbesondere in der ersten Schale (13A, 13B), für den Spannungsanschluss (53) und/oder den mindestens einen ersten CT-Anschluss (51), und/oder Öffnungen, insbesondere in der zweiten Schale, für den mindestens einen Datenanschluss (59) und der mindestens einen Benutzerschnittstelle (61) aufweist, wobei die Benutzerschnittstelle (61) insbesondere über ein zwischen der Kommunikationsplatine (33) und der zweiten Schale (11) angeordnetes Lichtleiter-und/oder-Stößel-Element (37) für einen Benutzer zugänglich gemacht ist.

6. Messgerät (1) nach einem der vorhergehenden Ansprüche, wobei das Gehäuse (3) als zweigeteiltes Gehäuse eine erste Schale (13A, 13B) und eine zweite Schale (11) umfasst und eine Rastverbindung zum mechanischen Verbinden der ersten Schale (13A, 13B) mit der zweiten Schale (11) aufweist, wobei die Rastverbindung von mindestens einem Rasthacken (17) und mindestens einem Einrastbereich, insbesondere eine Öffnung (21), an entsprechend der ersten Schale (13A, 13B) und der zweiten Schale (11) gebildet wird, wobei
das Messgerät (1) ferner ein zwischen der Messplatine (31) und der Kommunikationsplatine (33) angeordnetes Formteil (81) mit mindestens einem Blockade-Element (81A, 81B) umfasst, wobei das mindestens eine Blockade-Element (81A, 81B) im eingebauten Zustand derart zu einem Rasthaken (17) angeordnet ist, dass einem Ausrasten der Rastverbindung, insbesondere einem Verformen des zugehörigen Rasthakens (17) in Richtung eines Gehäuseinneren (83), entgegengewirkt wird, ein Ausrasten insbesondere verhindert wird.

7. Messgerät nach Anspruch 6, wobei die Rastverbindung auf gegenüberliegenden Seiten des Gehäuses (3) angeordnete Rasthaken (17) aufweist und das Formteil (81) derart ausgebildet ist, dass es einem Ausrasten mindestens eines der Rasthacken (17) auf jeder Seite des Gehäuses (3) entgegenwirkt.

8. Messgerät (1) nach Anspruch 6 oder 7, wobei das Formteil (81) derart ausgebildet ist, dass es im eingebauten Zustand einen Mindestabstand zwischen der Messplatine (31) und der Kommunikationsplatine (33) bereitstellt, und insbesondere sicherstellt, der insbesondere auch bei fehlender Verbindung eines oder beider der Messplatine (31) und der Kommunikationsplatine (33) zur jeweiligen der ersten und zweiten Schale (11, 13A, 13B) den Mindestabstand gewährleistet, und/oder
wobei das Formteil (81) aus einem elektrisch isolierenden Material ausgebildet ist.

9. Messgerät (1) nach einem der Ansprüche 6 bis 8, wobei das Formteil (81) umfasst
- mindestens einen Standfuß (85), der insbesondere im eingebauten Zustand in einem nicht-bestückten Bereich der Messplatine (31) angeordnet ist und dessen Länge insbesondere eine Position des mindestens einen Blockade-Elements (81A, 81B) im Gehäuseinneren (83), und insbesondere den Mindestabstand zwischen der Messplatine (31) und der Kommunikationsplatine (33), bestimmt, und/oder
- einen flächig ausgebildeten Strukturabschnitt (87), der mindestens eine Blockade-Element (81A, 81B) räumlich zu dem mindestens einen Rasthaken (17) positioniert, und/oder wobei das mindestens eine Blockade-Element (81A, 81B) im eingebauten Zustand in einem nicht-bestückten Bereich der Kommunikationsplatine (33) angeordnet ist.

10. Messgerät (1) nach einem der Ansprüche 6 bis 9, wobei das Formteil (81) und mindestens eine der ersten Schale (13A, 13B) und der zweiten Schale (11) ein Führungssystem (23) ausbilden, das zum Positionieren des Formteils (81) beim Zusammenbau des Messgeräts (1) und/oder zum Halten des Formteils (81) im eingebauten Zustand ausgebildet ist, wobei das Führungssystem insbesondere eine Führungsschiene (23), insbesondere eine Nut, auf einer Innenwand einer der ersten Schale (13A, 13B) und der zweiten Schale (11) oder am Formteil (81) und eine entsprechend in die Führungsschiene (23), insbesondere in die Nut, eingreifendes Schlittenelement (89) am Formteil (81) oder auf der Innenwand einer der ersten Schale (13A, 13B) und der zweiten Schale (11) umfasst.

11. Messgerät (1) nach einem der vorhergehenden Ansprüche, wobei der Spannungsteiler (57) zum Abgeben von reduzierten Spannungen an mindestens zwei Mess-Chips (45, 45') für die Messung von elektrischen Größen mittels zwei an die jeweiligen Mess-Chips (45, 45') angeschlossenen externen Stromwandlern (49) ausgebildet ist, und wobei der Spannungsteiler (57) umfasst
- einen Spannungseingang (Lx), insbesondere zum Aufnehmen einer Netzspannung,
- für jeden der mindestens zwei Mess-Chips (45, 45'), einen Spannungsausgang (CH1-VA, CH2-VA) zum Abgeben einer der reduzierten Spannungen an einen der mindestens zwei Mess-Chips (45, 45'),
- einen mit dem Spannungseingang (Lx) elektrisch verbundenen Widerstandsreihenabschnitt (101) umfassend mehrere in Reihe geschaltete Widerstände (R1-1, R1-2..., R1-4), die zum Spannungsabfall für jeden der mindestens zwei Mess-Chips (45, 45') beitragen, und
- eine mit einem letzten Widerstand (R1-4) der Widerstände des Widerstandsreihenabschnitts (101) elektrisch verbundenen Parallelschaltungsabschnitt (103) umfassend,
- für jeden der mindestens zwei Mess-Chips (45, 45') einen die in Reihe geschaltete Widerstände des Widerstandsreihenabschnitts (101) erweiternden und mit jeweils einem Spannungsausgang (CH1.VA, CH2.VA) elektrisch verbundenen Widerstand (CH1.R1-5, CH2.R1-5) und
- für jeden Spannungsausgang (CH1.VA, CH2.VA) einen den jeweiligen Spannungsausgang (CH1.VA, CH2.VA) und einem Neutralleiter (N) elektrisch verbindenden Widerstand (CH1.R2, CH2.R2) und einen den jeweiligen Spannungsausgang (CH1.VA, CH2.VA) und den Neutralleiter (N) elektrisch verbindenden Kondensator (CH1.C1, CH2.C1).

12. Messgerät (1) nach Anspruch 11, wobei die Messplatine (31) bestückt ist mit
- einem zweiten CT-Anschluss (51) zum Anschließen mindestens eines externen Stromwandlers (49) und
- einem mit dem Spannungsteiler (57) und dem zweiten CT-Anschluss (59) elektrisch verbundenen zweiten Mess-Chip (45') zum Bestimmen der elektrischen Größen und Ausgeben der elektrischen Größen an die Kommunikationsplatine (33) als Messdaten für den mindestens einen mit dem am zweiten CT-Anschluss (59) angeschlossenen externen Stromwandler (49), und
wobei der erste Mess-Chip (45) mit einem ersten Spannungsausgang (CH1.VA) und der zweite Mess-Chip (45') mit einem zweiten Spannungsausgang (CH2.VA) elektrisch verbunden sind.

13. Messgerät (1) nach Anspruch 11 oder Anspruch 12, wobei der Spannungsteiler (57) zum Reduzieren einer Eingangsspannung in einem Bereich von 200 V bis 1000 V in einen Messpannungsbereich in einem Bereich von 0 V bis 3 V ausgebildet ist und/oder wobei die, die in Reihe geschalteten Widerstände des Widerstandsreihenabschnitts (101) erweiternden, Widerstände (CH1.R1-5, CH2.R1-5) zwischen dem jeweiligen Spannungsausgang (CH1.VA, CH2.VA) und dem Neutralleiter (N) eine Entkopplung zwischen den Spannungsausgängen (CH1.VA, CH2.VA) bewirken.

14. Messgerät (1) nach einem der Ansprüche 11 bis 13, wobei die Widerstände des Widerstandsreihenabschnitts (101) einen Gesamtwiderstand (R1) in einen Bereich von 500 kS2 bis 10 MS2 ausbilden und/oder der Parallelschaltungsabschnitt (103) einen Widerstand in einem Bereich von 100 Ω bis 10 kS2 ausbildet, sodass zusammen mit dem Widerstand (CH1.R2, CH2.R2) zwischen dem jeweiligen Spannungsausgang (CH1.VA, CH2.VA) und dem Neutralleiter (N) eine Spannungsteilung am jeweiligen Spannungsausgang umgesetzt ist, und/oder
wobei für den jeweiligen Spannungsausgang (CH1.VA, CH2.VA) die Widerstände des Widerstandsreihenabschnitts (101) und der Widerstand (CH1.R2, CH2.R2) zwischen dem jeweiligen Spannungsausgang (CH1.VA, CH2.VA) und dem Neutralleiter (N) mit dem Kondensator (CH1.C1, CH2.C1) zwischen dem jeweiligen Spannungsausgang (CH1.VA, CH2.VA) und dem Neutralleiter (N) eine RC-Tiefpassfunktion ausbilden, und/oder
wobei der Kondensator (CH1.C1, CH2.C1) zwischen dem jeweiligen Spannungsausgang (CH1.VA, CH2.VA) und dem Neutralleiter (N) eine Pufferfunktion für den jeweiligen Spannungsausgang (CH1.VA, CH2.VA) ausbildet.

15. Elektrogerät, insbesondere zum Messen elektrischer Größen, mit:
einer elektrischen Schaltungsanordnung, insbesondere zum Bestimmen und Ausgeben der elektrischen Größen, die einen Spannungsanschluss und mindestens eine Benutzerschnittstelle umfasst und in einem Gehäuse angeordnet ist, wobei das Gehäuse als zweigeteiltes Gehäuse eine erste Schale und eine zweite Schale umfasst und eine Rastverbindung zum mechanischen Verbinden der ersten Schale mit der zweiten Schale aufweist, wobei die Rastverbindung von mindestens einem Rasthacken und mindestens einem Einrastbereich an entsprechend der ersten Schale und der zweiten Schale gebildet wird, wobei
das Elektrogerät ferner ein im Gehäuse angeordnetes Formteil umfasst, das mindestens ein Blockade-Element ausbildet, das im eingebauten Zustand derart zum Rasthaken angeordnet ist, dass einem Ausrasten der Rastverbindung, insbesondere einem Verformen des Rasthakens in Richtung eines Gehäuseinneren, entgegengewirkt wird.

16. Messgerät (1) für elektrische Größen mit:
Einer elektrischen Schaltungsanordnung (1'), wobei die elektrische Schaltungsanordnung (1) umfasst
- einen Spannungsanschluss (53),
- einen mit dem Spannungsanschluss (53) elektrisch verbundenen Spannungsteiler (57),
- einen ersten CT-Anschluss (51) zum Anschließen mindestens eines externen Stromwandlers (49) und einen zweiten CT-Anschluss (51) zum Anschließen mindestens eines externen Stromwandlers (49),
- einen mit dem Spannungsteiler (57) und dem ersten CT-Anschluss (51) elektrisch verbundenen ersten Mess-Chip (45) zum Bestimmen und zum Ausgeben der elektrischen Größen als Messdaten für den mindestens einen mit dem am ersten CT-Anschluss (52) angeschlossenen externen Stromwandler (49),
- einen mit dem Spannungsteiler (57) und dem zweiten CT-Anschluss (51) elektrisch verbundenen zweiten Mess-Chip (45') zum Bestimmen und zum Ausgeben der elektrischen Größen als Messdaten für den mindestens einen mit dem am zweiten CT-Anschluss (51) angeschlossenen externen Stromwandler (49),
- einen Datenkommunikationschip (43), der zum Empfangen, Verarbeiten und Ausgeben der Messdaten vom ersten Mess-Chip (45) und vom zweiten Mess-Chip (45') ausgebildet ist, und
wobei der Spannungsteiler (57) zum Abgeben von Spannungen an den ersten Mess-Chip (45) und den zweiten Mess-Chip (45') ausgebildet ist und umfasst
- einen Spannungseingang (Lx) zum Aufnehmen einer Eingangsspannung vom Spannungsanschluss (53),
- für jeden der Mess-Chips (45, 45'), einen Spannungsausgang (CH1-VA, CH2-VA) zum Abgeben einer reduzierten Spannung an den jeweiligen Mess-Chip (45, 45'),
- einen mit dem Spannungseingang (Lx) elektrisch verbundenen Widerstandsreihenabschnitt (101) umfassend mehrere in Reihe geschaltete Widerstände (R1-1, R1-2..., R1-4), die zum Spannungsabfall für jeden der Mess-Chips (45, 45') beitragen, und
- einen mit einem letzten Widerstand (R1-4) der Widerstände des Widerstandsreihenabschnitts (101) elektrisch verbundenen Parallelschaltungsabschnitt (103) umfassend, für jeden Spannungsausgang (CH1.VA, CH2.VA),
- einen, die in Reihe geschaltete Widerstände des Widerstandsreihenabschnitts (101) erweiternden und mit jeweils einem Spannungsausgang (CH1.VA, CH2.VA) elektrisch verbundenen, ersten Widerstandsabschnitt (103A) umfassend mindestens einen Widerstand (CH1.R1-5, CH2.R1-5),
- einen den jeweiligen Spannungsausgang (CH1. VA, CH2.VA) und einen Neutralleiter (N) elektrisch verbindenden zweiten Widerstandsabschnitt (103B) umfassend mindestens einen Widerstand (CH1.R2, CH2.R2) und
- einen den jeweiligen Spannungsausgang (CH1.VA, CH2.VA) und den Neutralleiter (N) elektrisch verbindenden Kondensatorabschnitt (103C) umfassend mindestens einen Kondensator (CH1.C1, CH2.C1).

17. Messgerät (1) nach Anspruch 16, ferner umfassend einen weiteren CT-Anschluss (51) zum Anschließen eines weiteren externen Stromwandlers (49) und einen weiteren Mess-Chip (45), und
wobei der Parallelschaltungsabschnitt (103) ferner für einen weiteren, dem weiteren Mess-Chip zugeordneten, Spannungsausgang einen weiteren ersten Widerstandsabschnitt (103A), einen weiteren zweiten Widerstandsabschnitt (103B) und einen weiteren Kondensatorabschnitt (103C) umfasst.
